(19) Europäisches Patentamt
European Patent Office
Office européen des brevets

(11) **EP 4 474 834 A1**

(12) **EUROPEAN PATENT APPLICATION**

(43) Date of publication:
**11.12.2024 Bulletin 2024/50**

(21) Application number: **23178080.0**

(22) Date of filing: **07.06.2023**

(51) International Patent Classification (IPC):
**G01R 23/165** (2006.01)

(52) Cooperative Patent Classification (CPC):
**G01R 23/165**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: **AARONIA AG**
**54597 Strickscheid (DE)**

(72) Inventors:
• **Chmielus, Thorsten**
  **54597 Strickscheid (DE)**
• **Ringelberg, Jörg**
  **27755 Delmenhorst (DE)**
• **Sigmund, Ulrich**
  **79183 Waldkirch (DE)**

(74) Representative: **Hermann, Felix**
**Boehmert & Boehmert**
**Anwaltspartnerschaft mbB**
**Pettenkoferstrasse 22**
**80336 München (DE)**

(54) **SPECTRUM ANALYZER DEVICE AND PROCEDURES FOR OPERATING A SPECTRUM ANALYZER DEVICE**

(57)    This disclosure relates to a direct conversion (zero-IF) architecture receive chain for use in a spectrum analyzer, where a local oscillator produces a local oscillator signal that has signal components at a clock frequency and at odd harmonics at odd multiples of the clock frequency. The local oscillator signal, including the signal components at a clock frequency and at its odd harmonics is fed into a mixer together with a radio frequency input signal for analog multiplication. The RF path may include a bandpass filter that filters the radio frequency input signal prior to its input to the mixer. The bandpass filter removes frequency components that are outside frequency span of the bandpass filter, where the frequency span of the bandpass filter is selected to match with a desired one of the frequency components of the local oscillator signal. The bandpass filter may be further configured to reject frequencies of the other, non-selected harmonic frequencies.

Fig. 3

**Description**

**Field of the Invention**

This disclosure generally relates to a spectrum analyzer device and procedures for operating a spectrum analyzer device. Another aspect of the disclosure is the processing of radio frequency (RF) signals in the spectrum analyzer device.

**Technical Background**

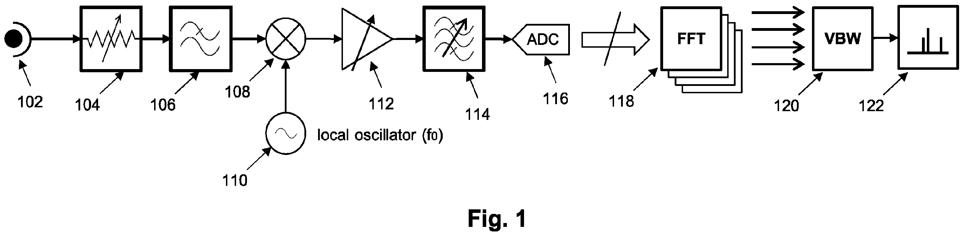

Spectrum analyzer devices for use with RF signals in the range of several tens of gigahertz (GHz) are commonly use a zero-IF receive chain to provide a real-time view of the RF signal connected to the spectrum analyzer devices. An example block diagram of a real-time spectrum analyzer architecture with zero-IF receive chain is shown in Fig. 1. The spectrum analyzer accepts a RF signal at its input RF connector 102. The RF input signal may be fed into an RF input attenuator 104 which attenuates the RF input signal and provides an attenuated RF input signal to the pre-selector block or low-pass filter block 106. The pre-selector block or low-pass filter 106 performs a low-pass filtering of the RF input signal to block a lower range of frequencies in the RF input signal to enter the mixer 108.

The mixer 108 performs an analog multiplication of the incoming RF input signal with a clock signal of the local oscillator 110. This multiplication in the time domain results in a frequency shift of the RF input signal by the frequency $f_0$ of the local oscillator 110. The resultant frequency of the signal output by the mixer 108 is at baseband (BB) (i.e. commonly at 0°, unless using a superheterodyne receive chain). The BB gain 112 attenuates the BB signal from mixer 108 and the BB filter 114 prevents frequencies of the BB signal which are beyond the Nyquist range of the Analog-to-Digital Converter (ADC) 116 to alias into the digital input signal output by the ADC 116. Conventionally, the BB filter 114 is a low-pass filter with a cutoff less than half of the ADC 116's sample rate. The sample rate of the ADC 116 determines the span or frequency band that can be measured and analyzed by the spectrum analyzer device in real time. In many scenarios the ADC 116 samples at a higher frequency than the processing frequency of the later signal analysis steps and digital filters. Sometimes, downconverters are used to provide a steeper filter and thus better alias suppression. For example, assume that the ADC 116 operates at a sample frequency of 250MHz. Using a local oscillator 110 with a clock frequency $f_0$ of 1GHz, the frequency range digitized would be 0.875GHz to 1.125GHz (although not the entire frequency range may be usable due to the finite steepness of the BB filter 114).

The time-discrete input signal output by the ADC 116 may then be transformed into the frequency domain, as indicated by the FFT block 118, and the frequency domain representation of the time-discrete input signal may be subjected to a video bandwidth filter 120 prior to generating a view of the time-discrete input signal for display on a display device 122 of the spectrum analyzer.

The input RF connector 102, RF input attenuator 104 and pre-selector block or low-pass filter 106 may be considered forming the RF path of the receive chain, whereas the mixer 108, BB gain 112, BB filter 114 and ADC 116 may be considered forming a baseband (BB) path of the receive chain.

In most applications the signal generated by the local oscillator 110 is not a pure sine wave at a given frequency $f_0$ but contains various harmonics that result in signals outside of the measurement range to be aliased into the baseband signal. The RF filter106 is commonly designed as a low-pass filter that prevents those unwanted frequencies in the range of local oscillator's harmonics to enter the mixer 108. Continuing the example above, the RF filter 106 would thus need to have a pass band of approx. 1.15 GHz and a stop band at the first harmonic at 2.00 GHz minus half the span frequency resulting in 1.875 GHz.

When using a tunable local oscillator 116 that supports a large range of local oscillator frequencies the RF filter106 would conventionally be realized by a cascade of low-pass RF filters, or a tunable low-pass filter.

The local oscillator 116' clock frequency may also not have a perfect duty cycle or may not be centered around a zero value (DC offset), which will also result in non-wanted RF input signal frequencies to pass through the mixer 108. The RF filter 106 thus often includes a high-pass filter, that prevents baseband signals to enter the ADC 116, i.e. that have a passband selected based on the ADC 116's requirements.

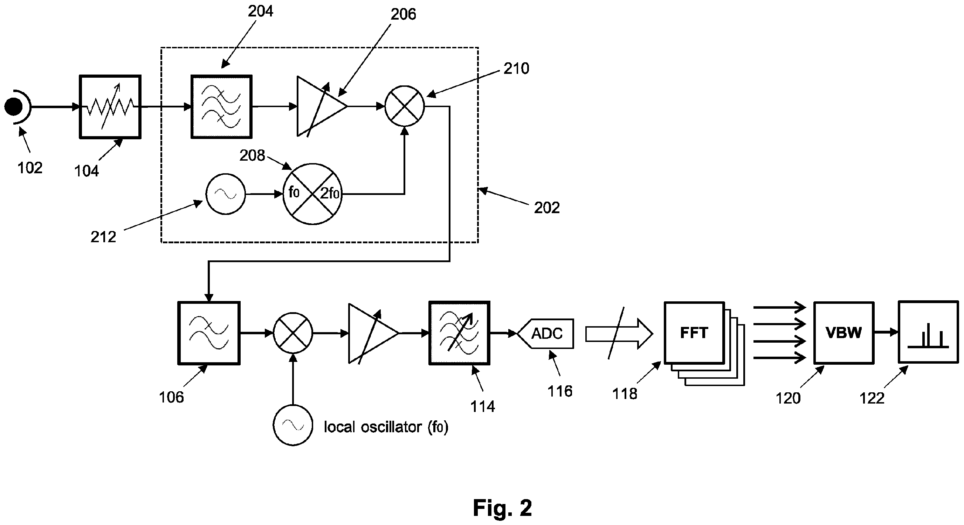

To increase the frequency range of the spectrum analyzer one may add an additional mixer stage before the RF filter 106. Fig. 2 shows a simplified two-mixer architecture of a spectrum analyzer using a zero-IF receive chain (i.e. direct conversion of the RF input signal), which can be considered an extension of the block diagram of the spectrum analyzer architecture in **Fig. 1.** A second mixer stage 202 is added in between the RF input attenuator 104 and the RF filter 106. The second mixer stage 202 has its own RF input filter 204 that provides a pre-selection of frequency band of the RF input signal to be processed in the second mixer stage 202. An RF gain control 206 amplifies the RF input signal received from the RF input filter 204, and a second mixer 210 that performs an analog multiplication of the incoming RF input signal with a clock signal (at frequency $2f_0$) provided by a frequency multiplier 208 that doubles the clock frequency $f_0$ of the local oscillator 212. This two-mixer approach is a common method in commercial spectrum analyzers or is available as additional and cost-intensive additional equipment for spectrum analyzers.

**Summary**

In the light of the above, there may be a need for a spectrum analyzer architecture that is capable of operating at a large frequency range (e.g. from the low kilohertz (kHz) range or megahertz (MHz) range up to range of tens of gigahertz) without requiring a multi-stage mixer architecture and/or with reduced hardware complexity as regards the different filters in the RF path and/or IF path.

One approach in line with one aspect may be the utilization of a harmonic mixer (instead of local oscillator 110 and mixer 108), which commonly utilize a nonlinear device, e.g. a diode for mixing. When using a harmonic mixer, the desired signal component at either a clock frequency $f_0$ or an (odd) harmonic of the clock frequency $f_0$ needs to be selected from the output signal of mixer. For this, harmonic mixer implementations commonly require complex additional filter circuits (e.g. bandpass filters) that ensure that desired signal component at the clock frequency $f_0$ or at one of multiple available harmonics of the clock frequency $f_0$ can selected from the mixer output. This may be undesirable, for example for in integrated circuit (IC) implementations of the harmonic mixers, where the additional filter circuits add additional complexity in the IC design and require substantial area in the IC. Further, harmonic mixers based on diode implementations also require substantial power for operating the mixer circuit, e.g. in comparison to switching-type mixers that use transistors or similar switching elements.

In line with another approach and aspect of this disclosure, a direct conversion (zero-IF) architecture receive chain is used. In this architecture, a local oscillator produces a local oscillator signal that has signal components at a clock frequency (which may be tunable) and at (even and) odd harmonics at (even and) odd multiples of the clock frequency. This local oscillator signal, including the signal components at a clock frequency and at (even and) odd harmonics at (even or) odd multiples of the clock frequency, is fed together with a radio frequency input signal into a mixer. To avoid that the analog multiplication of the radio frequency input signal with the different signal components of the local oscillator signal will produce multiple images in response to the different signal components of the local oscillator signal, the RF path may include a bandpass filter that filters the radio frequency input signal prior to its input to the mixer. The bandpass filter removes frequency components that are outside frequency span of the bandpass filter, where the frequency span of the bandpass filter is selected to match with a desired one of the frequency components of the local oscillator signal, i.e. a selected one of the (even or) odd harmonics at (even or) odd multiples of the clock frequency (or the clock frequency itself).

One embodiment provides an apparatus for implementing this latter aspect of the disclosure. In one implementation, the apparatus may be or may be implemented as one or more integrated circuits (ICs) - e.g. a System on Chip, System-in-Package (SiP), etc. - or as a component of a system. Such apparatus may - for example and not limited thereto - be used in or realize a spectrum analyzer device, e.g. real-time spectrum analyzer. The apparatus has radio-frequency path that comprises at least a bandpass filter circuit. The bandpass filter circuit receives a time-continuous radio-frequency input signal (e.g. from an input connector) and outputs a bandpass-filtered radio frequency input signal that has frequency components that are outside a predetermined or configurable frequency span of the bandpass filter removed. Further, the apparatus includes a direct-conversion circuit that receives the bandpass-filtered time-continuous radio frequency input signal.

The direct-conversion circuit comprises a local oscillator circuit and a mixer. In one example implementation, the direct-conversion circuit may perform synchronous detection of the bandpass-filtered radio input frequency signal.

The local oscillator circuit provides a local oscillator signal which includes signal components at a clock frequency (of fundamental frequency) and odd harmonics at odd multiples of the clock frequency (3rd, 5th, 7th, ... harmonic). The predetermined or configurable frequency span of the bandpass filter implemented using the bandpass filter circuit includes frequencies around one of the odd harmonics of the local oscillator signal output from the local oscillator. The mixer circuit configured receives the local oscillator signal including the signal components at a clock frequency and odd harmonics at odd multiples of the clock frequency and said bandpass-filtered time-continuous radio frequency input signal, and mixes the local oscillator signal and the bandpass-filtered time-continuous radio frequency input signal, thereby generating a time-continuous baseband signal including signal components at frequencies around said one of the odd harmonics of the local oscillator signal. This mixing may realize a down conversion of the radio frequency input signal. A display device or may cause a separate display device to visualize the continuous radio-frequency input signal based on the baseband signal including said signal components at frequencies around said one of the odd harmonics of the local oscillator signal. The display device may be part of the apparatus or may be realized as a separate component of the system.

According to an example embodiment, the frequency span of the bandpass filter has a predetermined or configurable center frequency. The center frequency corresponds to said one of the odd harmonics of the local oscillator signal but may also be predetermined or configurable to correspond to the clock frequency of the local oscillator signal provided by the local oscillator circuit. In addition, or alternatively, the baseband filter is configured to reject frequency components of the time-continuous radio-frequency input signal at the clock frequency and the odd harmonics other than said one of the odd harmonics of the local oscillator signal.

The apparatus of another embodiment may further comprise an analog-to-digital conversion (ADC) circuit configured to convert the time-continuous baseband signal into a time-discrete baseband signal. The bandpass filter circuit may be configurable to match or may be matched to the ADC circuit. In one example implementation the frequency span of the bandpass filter in the RF path has a predetermined or configurable bandwidth around a center frequency and the bandwidth corresponds to the instantaneous bandwidth of the analog-to-digital circuit defined by its sampling rate.

In another embodiment, the apparatus or another component in the system may process the time-discrete baseband signal. For example, the apparatus or other device in the system may comprise a time-frequency conversion circuit to transform the time-discrete baseband signal into the frequency domain thereby producing a frequency domain representation of the baseband signal. Furthermore, the display device may visualize the frequency domain representation of the baseband signal.

In some example embodiments, the direct-conversion circuit is an in-phase-quadrature mixer circuit (IQ mixer circuit) that mixes (e.g. by performing an analog multiplication) the local oscillator signal and the bandpass-filtered time-continuous radio frequency input signal, thereby generating an in-phase, I, component of the time-continuous baseband signal including signal components at frequencies around said one of the odd harmonics of the local oscillator signal. The IQ mixer circuit further mixes (e.g. by performing an analog multiplication) the a $\pi/2$-shifted version of the local oscillator signal and the bandpass-filtered time-continuous radio frequency input signal, thereby generate a quadrature, Q, component of the time-continuous baseband signal including signal components at frequencies around said one of the odd harmonics of the local oscillator signal. The IQ mixer circuit or the local oscillator may further include circuitry to produce the $\pi/2$-shifted version of the local oscillator signal.

Another aspect of this disclosure, which can be used in the above system and/or implemented in the above apparatus, relates to the signal processing of the time-continuous baseband signal as produced by the ADC circuit. The ADC circuit may for example perform analog-to-digital conversion of the I component and Q component of the time-discrete baseband signal to produce respective time-discrete signal components. The apparatus or another component in the system may further comprise a compensation circuit that compensate a phase shift between the I component and Q component of the time-discrete baseband signal. For this, the compensation circuit may for example estimate the phase shift $\Delta_{phase}$ using:

$$\Delta_{phase} = -\frac{1}{2}\tan^{-1}\frac{2\left(\frac{1}{n}\sum_{i=1}^{n}I_iQ_i - \left(\frac{1}{n}\sum_{i=1}^{n}I_i\right)\left(\frac{1}{n}\sum_{i=1}^{n}Q_i\right)\right)}{\left[\frac{1}{n}\sum_{i=1}^{n}I_i{}^2 - \left(\frac{1}{n}\sum_{i=1}^{n}I_i\right)^2\right] - \left[\frac{1}{n}\sum_{i=1}^{n}Q_i{}^2 - \left(\frac{1}{n}\sum_{i=1}^{n}Q_i\right)^2\right]}$$

wherein $I_i$ and $Q_i$ are the I and Q components of a sequence of n samples of the time-discrete baseband signal. The compensation circuit may then use this estimate for compensation of the phase shift $\Delta_{phase}$.

Additionally, or alternatively, the same or another compensation circuit of the apparatus or the other component of the system may compensate for a DC offset in the I and Q components of the time-discrete baseband signal by subtracting an average of a sequence of n samples of the I components and an average of sequence of n samples of the Q components from the I and Q components, respectively. This compensation of the DC offset may be performed prior to visualization. In one example the DC offset $I_{dc}$ for the I component and DC offset $Q_{dc}$ for the Q component are estimated as follows:

$$I_{dc} = \frac{1}{n}\sum_{i=1}^{n}I_i$$

$$Q_{dc} = \frac{1}{n}\sum_{i=1}^{n}Q_i$$

wherein $I_i$ and $Q_i$ are the I and Q components of a sequence of n samples of the time-discrete baseband signal.

Optionally, the compensation circuit may further scale the I and Q components using a scaling factor, which may be based on a ratio of the square root of the averages of the squares of the sequence of n samples of I components minus the square of the averages of the sequence of n samples of I components and the square root of the averages of the squares of the sequence of n samples of Q components minus the square of the averages of the sequence of n samples of Q components. The scaling factor may thus be determined by:

$$I_{scale} = \sqrt{\frac{\frac{1}{n}\sum_{i=1}^{n} I_i^2 - \left(\frac{1}{n}\sum_{i=1}^{n} I_i\right)^2}{\frac{1}{n}\sum_{i=1}^{n} Q_i^2 - \left(\frac{1}{n}\sum_{i=1}^{n} Q_i\right)^2}}$$

wherein $I_i$ and $Q_i$ are the I and Q components of a sequence of n samples of the time-discrete baseband signal.

In another embodiment, the same or another compensation circuit of the apparatus or the other component of the system may comprise a queuing circuit configured to queue a sequence of n samples of the I and Q components of the time-discrete baseband signal. For example, this queuing circuit may be used to buffer latest n samples of the I and Q components as they arrive from the ADC circuit in order to determine one or more of the phase offset, DC offsets or scaling factor for compensation. In one implementation, the above noted estimates of the one or more of phase offset, DC offsets or scaling factor may be implemented using a multi-tap filter bank that includes the queuing circuit and performs the above noted estimation(s). In other example implementations, one or more of or a combination of a field programmable gate array (FPGA), programmable logic device (PLD), application specific integrated circuit (ASIC), a digital signal processor (DSP), or another processing element may be used to determines the estimates of the one or more of phase offset, DC offsets or scaling factor.

In another further embodiment, the apparatus or the other component of the system may comprise a time-frequency conversion circuit configured to transform the I component and Q component of the time-discrete baseband signal into the frequency domain thereby producing a frequency domain representation of the I and Q components of the baseband signal. The display device is configured or caused to visualize the frequency domain representation of the I and Q components of the baseband signal.

In some embodiments, the local oscillator signal is a local oscillator signal is a rectangular wave signal. For example, the local oscillator may be a (digital) switching-type local oscillator, which outputs the local oscillator signal and optionally one or more phase shifted versions thereof by means of switching transistors. The rectangular wave signal may for example have a duty cycle of 50% (noting that there may be slight deviations due to the switching time and/or delays in the local oscillator circuit). Due to the local oscillator signal being a rectangular wave signal, the local oscillator signal comprises a clock frequency and odd harmonics at odd multiples of the clock frequency. Note that the disclosure is not limited to the use of rectangular wave signal being output from the local oscillator circuit. Other oscillator waveforms can also be used as long as the local oscillator signal comprises the odd harmonics of the clock frequencies (and/or even harmonics thereof) that have a sufficient power level in the spectrum. For example, the local oscillator circuit may also output a sawtooth wave, a triangle-wave, etc. which may exhibit harmonics at sufficient power levels in their frequency spectrum.

In another example embodiment, the local oscillator is tunable to a clock frequency within a range of clock frequencies. The local oscillator signal includes signal components at the tuned clock frequency and odd harmonics at odd multiples of the tuned clock frequency. Furthermore, the bandpass filter circuit may also be tunable or configurable to adjust the frequency span of the bandpass filter to select one of the tuned clock frequency and odd harmonics at odd multiples of the tuned clock frequency. Further, in another example implementation the apparatus comprises or received control signals from a controller. The controller may sweep the range of clock frequencies by step-wise tuning the local oscillator to the clock frequencies in said range and adjust the frequency span of the bandpass filter to include frequencies around each currently tuned clock frequency of the local oscillator or around its (odd) harmonics in said sweeping. The display device may be further caused to visualize the continuous radio-frequency input signal based on different baseband signals including signal components at frequencies around one of the odd harmonics of the local oscillator signal at the different tuned clock frequencies produced by said sweeping.

Another aspect and embodiment of the disclosure relates to a method which may be for example executed in a system or apparatus for processing a continuous radio-frequency input signal. The processing may be performed for providing a display of the radio-frequency input signal. The method may for example comprise, in a radio-frequency path, performing a bandpass filtering on a time-continuous radio-frequency input signal to produce a bandpass-filtered radio frequency input signal that has frequency components that are outside a predetermined or configurable frequency span of the bandpass filter removed; and performing a direct down conversion of the bandpass-filtered time-continuous radio frequency input signal into a baseband signal, wherein the direct down conversion comprises mixing a local oscillator signal including signal components at a clock frequency and odd harmonics at odd multiples of the clock frequency and said bandpass-filtered time-continuous radio frequency input signal, thereby generating the baseband signal, wherein the baseband signal includes signal components at frequencies around said one of the odd harmonics of the local oscillator signal.

In a further embodiment, the method further comprises causing a display device to visualize the continuous radio-frequency input signal on a display device based on the baseband signal including said signal components at frequencies around said one of the odd harmonics of the local oscillator signal. For example, this may include converting the time-continuous baseband signal into a time-discrete baseband signal; transforming the time-discrete baseband signal into the frequency domain thereby producing a frequency domain representation of the baseband signal; and causing visualization of the frequency domain representation of the baseband signal on the display device.

In a further embodiment, the baseband filtering rejects frequency components of the time-continuous radio-frequency input signal at the clock frequency and the odd harmonics other than said one of the odd harmonics of the local oscillator signal.

According to a further embodiment, the method comprises sweeping a range of clock frequencies by step-wise tuning the local oscillator to the clock frequencies in said range; adjusting the frequency span of the bandpass filtering to include frequencies around each currently tuned clock frequency of the local oscillator or one of its harmonics while sweeping the range of clock frequencies; and causing the display device to visualize the continuous radio-frequency input signal based on different baseband signals including signal components at frequencies around one of the odd harmonics of the local oscillator signal at the different tuned clock frequencies produced by said sweeping.

The method in further embodiments may also include steps implementing the functionality of the above-described system, its components and apparatus and in accordance with any of their embodiments described herein.

The disclosure also contemplates the method or individual steps thereof being implemented by means of a software instructions or programs (e.g. implementation of control functionality for configuration of the frequency band and/or center frequency of the bandpass filter implemented by the bandpass filter circuit, for tuning the local oscillator to one of its frequencies, or the processing of the time-discrete signals output by the ADC circuit, such as and not limited to frequency transformation, corrections of one or more of phase offset, DC offset, scaling, etc., video bandwidth filtering, etc.). Thus, embodiments of the disclosure also provide one or more computer-readable media that store instructions that, when executed by some processing element, e.g. a CPU, DSP, FPGA, ASIC, PLD, etc. cause, for example and not limited to the examples, the execution of the processing of the time-discrete signals output by the ADC circuit and/or control of the local oscillator circuit and/or bandpass filter circuit.

**Brief Description of Drawings**

The following detailed description refers to the accompanying drawings. The same reference numbers are used in different drawings to identify the same or similar elements. In the following description, for purposes of explanation and not limitation, specific details are set forth such as particular structures, architectures, interfaces, techniques, etc. in order to provide a thorough understanding of the various aspects of various embodiments. However, it will be apparent to those skilled in the art having the benefit of the present disclosure that the various aspects of the various embodiments may be practiced in other examples that depart from these specific details. In certain instances, descriptions of well-known devices, circuits, and methods are omitted so as not to obscure the description of the various embodiments with unnecessary detail.

**Fig. 1** shows an example block diagram of a real-time spectrum analyzer architecture with zero-IF receive chain;

**Fig. 2** shows an example block diagram of a real-time spectrum analyzer architecture with zero-IF receive chain having a multi-stage mixer architecture;

**Fig. 3** shows an example block diagram of a zero-IF receive chain in accordance with an embodiment of this disclosure;

**Fig. 4** shows an example of the signal processing of I and Q samples in accordance with an embodiment of this disclosure;

**Fig. 5** shows example implementation of an I-Q mixer in accordance with an embodiment of this disclosure;

**Fig. 6** illustrates phase shift between I and Q components of the radio frequency input signal for different harmonics used in direct conversion;

**Fig. 7** shows an example vector scope image where different DC offsets are present in the I and Q samples;

**Fig. 8** shows an example vector scope image where the average sum of absolute values of I and Q samples is not identical;

**Fig. 9** shows an example vector scope image where the phase offset between the I and Q samples is not 90°;

**Fig. 10** shows an example of an ideal vector scope image, where there is no DC offset, no phase offset between the I and Q samples is 90° and where the average sum of absolute values of I and Q samples is identical;

**Figs. 11 and 12** show on their left side the time domain representation of a cosine wave signal ("RF"), a local oscillator signal ("LO"), a baseband signal ("BB"), and a filtered baseband signal ("BB") with example embodiments of this disclosure;

**Fig. 13** shows an example baseband filter and its parameters with an embodiment of this disclosure; and

**Fig. 14** highlights different possibilities for implementing the aspects of this disclosure in hardware (e.g. integrated circuits).

## Detailed Description

As noted, one possible approach to realize an RF receive chain which is capable of operating at an increased frequency range up to the range of tens of gigahertz without requiring a multi-stage mixer architecture may be the utilization of a harmonic mixer, where a mixers output is filtered to select either a tunable clock frequency $f_0$ or alternatively an (odd) harmonic of the clock frequency $f_0$. Although this approach might not require a multi-stage mixer architecture, the harmonic mixer require multiple additional filter circuits that ensure that the desired signal at the clock frequency $f_0$ or at one of the multiple available harmonics of the clock frequency $f_0$ in the mixer output are selected. Since mixers are commonly implemented in integrated circuits (IC), the harmonic mixer implementation may still require substantial power (e.g. in comparison to switching-type mixers), substantial area on the IC to implement the additional filter circuits to ensure that only the desired frequency component is selected in the mixer output.

Another approach that in line with another aspect of this disclosure elaborated in more detail below is a direct conversion (zero-IF) architecture receive chain, where a local oscillator produces a local oscillator signal that has signal components at a clock frequency (which may be tunable) and at odd harmonics at odd multiples of the clock frequency. The clock frequency is sometimes also denoted the fundamental frequency. This local oscillator signal, including the signal components at a clock frequency and at (even or odd) harmonics at (even or odd) multiples of the clock frequency, is fed into a mixer together with a radio frequency input signal for analog multiplication. To avoid that the analog multiplication of the radio frequency input signal with the different signal components of the local oscillator signal at the clock frequency and its harmonics will produce multiple images in response to the different signal components of the local oscillator signal, the RF path may include a bandpass filter that filters the radio frequency input signal prior to its input to the mixer. The bandpass filter removes frequency components that are outside frequency span of the bandpass filter, where the frequency span of the bandpass filter is selected to match with a desired one of the frequency components of the local oscillator signal, i.e. a selected one of the clock frequency or the (even or odd) harmonics at (even or odd) multiples of the clock frequency. The bandpass filter may be further configured to reject frequencies of the other, non-selected harmonic frequencies (and clock frequency in case it is not the selected frequency).

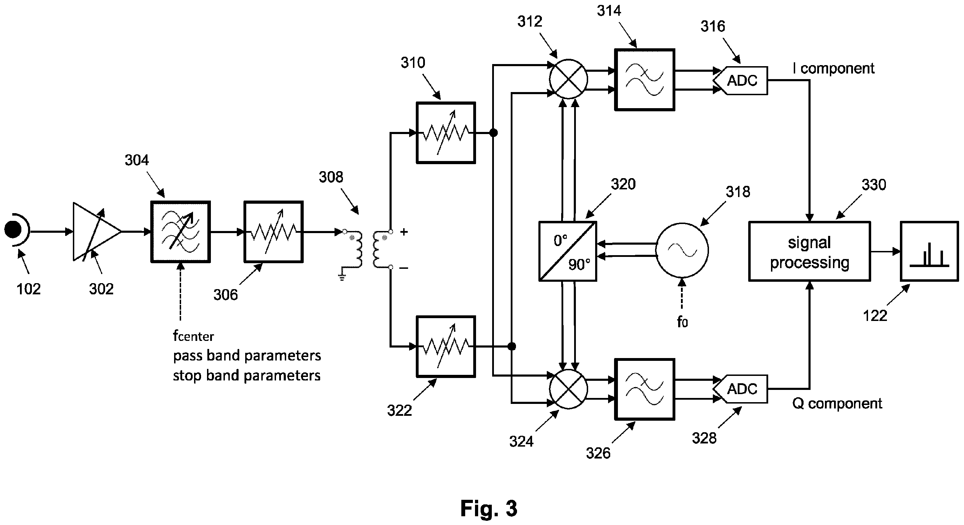

**Fig. 3** shows an example block diagram of a zero-IF receive architecture implemented in accordance with an embodiment of this disclosure. The architecture in Fig. 3 may be for example implemented in an apparatus that is a component of a system implementing a real-time spectrum analyzer. The zero-IF receive architecture has radio-frequency path that comprises a bandpass filter circuit 304. The bandpass filter circuit 304 receives a time-continuous radio-frequency input signal (e.g. from an input connector 102). The time-continuous radio-frequency input signal may be a RF signal at a frequency up to approx. 30 GHz, but the disclosure is not limited to this example. In the shown embodiment, the time-continuous radio-frequency input signal may be (optionally) amplified by the RF amplifier 302 prior to entering the bandpass filter circuit 304. The bandpass filter circuit 304 outputs a bandpass-filtered RF input signal that has frequency components that are outside a predetermined or configurable frequency span of the bandpass filter removed, as will be explained in more detail below.

The bandpass-filtered RF input signal may be (optionally) subjected to a damping using the RF attenuator 306. The RF attenuator 306 can be considered an electrical resistor that is to reduce the signal strength by converting some amount of RF energy of the bandpass-filtered RF input signal into heat. The bandpass-filtered and attenuated RF input signal is then fed to a balun 308 (for example, an unbalanced balun as shown in Fig. 3) that allows the balanced RF line on the side towards the RF connector 102 to interface unbalanced signal lines towards the subsequent elements of the zero-IF receive chain without disturbing the impedance arrangement.

The elements of the architecture at the output side of the balun 308 may be considered forming a direct-conversion circuit of the zero-IF architecture. The frequency mixers 312 and 324 perform a direct conversion of their RF input signals at the RF frequency into a baseband signal (sometimes also referred to as IF signal in a superheterodyne receive chains). The RF input signals on the positive signal line (indicated by the + sign) and on the negative signal line (indicated by the - sign) at the output of the balun 308 may be (optionally) subjected to attenuation in the attenuators 310 and 322 prior to the RF input signals being fed to the frequency mixers 312 and 324.

In this example, the frequency mixers 312 and 324 may be implemented as unbalanced or balanced frequency mixers that multiply the respective RF input signals with local oscillator signals in a known manner for down conversion into baseband. The frequency mixer 312 in the upper signal path and the frequency mixer 324 in the lower signal path receive local oscillator (LO) signals that are phase shifted by 90° ($\pi/2$) relative to each other to produce inphase (I) and quadrature (Q) components of the RF input signal. In the example shown, the phase shift is introduced by a phase shifting element 320 which shifts the phase of a LO clock signal produced by the local oscillator circuit 318 by 90° prior to input to the frequency mixer 324, while the frequency mixer 312 receives the non-shifted (0°) LO clock signal produced by the local oscillator circuit 318. The frequency mixers 312 and 324 may be considered forming an I-Q mixer circuit which produces inphase (I) and quadrature (Q) components, which represent the real and imaginary parts of the RF input signal, respectively. Accordingly, the upper signal path may also be referred to as the I path or I branch of the direct-conversion circuit, while the lower signal path may also be referred to as the Q path or Q branch of the direct-conversion circuit.

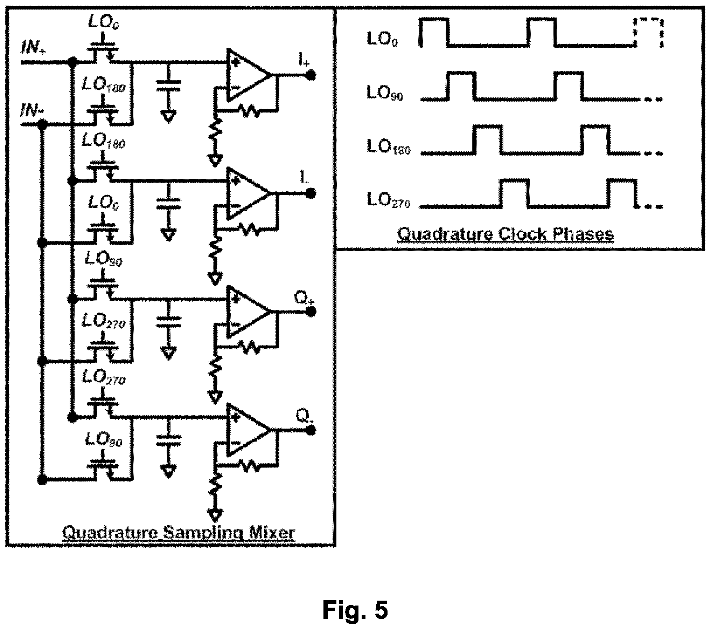

The baseband signals output by the frequency mixers 312 and 324 in the I and Q branches may be (optionally) subjected to a lowpass filtering in lowpass filter circuits 314 and 326, respectively. The (optional) lowpass filter circuits 314 and 326 may for example reject frequencies of the baseband signals output by the frequency mixers 312 and 324 that are outside the dynamic bandwidth of the analog-to-digital converters (ADC) 318 and 328, which convert the time-continuous baseband signals output by the frequency mixers 312 and 324 into time-discrete baseband signals. Thus, the lowpass filter circuits 314 and 326 may ensure that frequencies in the baseband signals that are beyond the Nyquist range of ADCs 318 and 328 do not alias into the time-discrete outputs by the of ADCs 318 and 328. For example, considering that ADC 318 and 328 sample the time-continuous baseband at 200 MHz, the lowpass filter circuits 314 and 326 may for example reject frequencies higher than 100 MHz in the baseband signals (assuming the baseband signals to be centered at 0 Hz). The ADC 318 outputs the sampled, time-discrete baseband signal representing the I component of the RF input signal at RF connector 102, while The ADC 328 outputs the sampled, time-discrete baseband signal representing the Q component of the RF input signal at RF connector 102. One example implementation of an I-Q mixer (also denoted quadrature sampling mixer) is shown in Fig. 5, which is a partial reproduction of Fig. 5 from the article by Jain et al., "Recent Developments in Integrated Interferer-Tolerant Receivers for Reconfigurable Radios", IEEE Journal of Microwaves, Volume: 1, Issue: 3, July 2021 (available at https://ieeexplore.ieee.org/document/9432393).

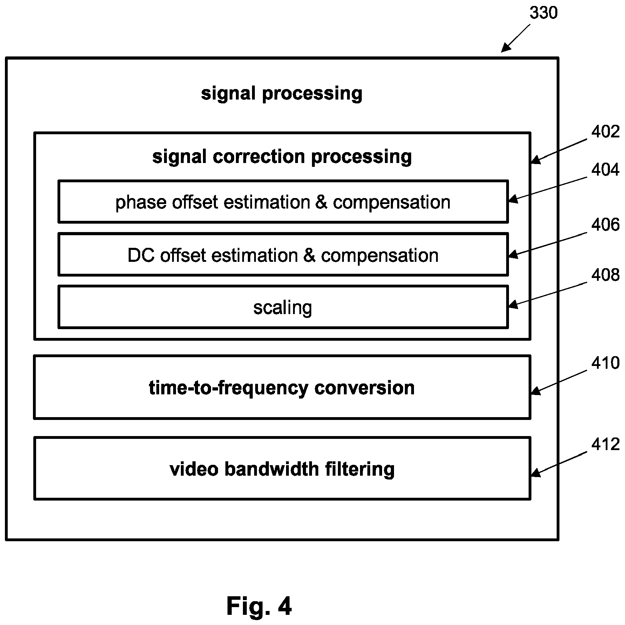

The I component and Q component of the RF input signal may further subjected to signal processing 330. For example, the I component and Q component of the RF input signal may be fed via a data interface to some processing unit that may for example perform corrections of the I component and Q component of the RF input signal and/or prepare the I component and Q component of the RF input signal for visualization on some display device 122 (e.g. when displaying the I component and Q component of the RF input signal using a real-time spectrum analyzer), as will be elaborated below in more detail in connection with Figs. 4 and 6 to 10. The processed signals may be presented to a user on a display screen. For example, the processed I component and Q component of the RF input signal may be used to generate a view (e.g. vector scope view) of the RF input signal for display on the display device 122 that is part of or connected to the spectrum analyzer.

According to embodiments of this disclosure, the LO signal output from the local oscillator 318 has signal components at a clock frequency $f_0$ and at (even and) odd harmonics at (even or) odd multiples of the clock frequency $f_0$. The clock frequency $f_0$ of the local oscillator 318 may be for example tunable in a given frequency range (e.g. from 0 Hz to 6 GHz). The LO signal including the signal components at the (tuned) clock frequency $f_0$ and its harmonics are fed into the frequency mixers 312 and 324 for analog multiplication with the time-continuous RF input signals. Hence, the LO signal is not a pure sine wave, but may substantially take any waveform that produces harmonics at multiples of the base frequency. For example, in some embodiments, the LO signal of the local oscillator 318 is a rectangular wave signal. The rectangular wave signal may for example have a duty cycle of 50% (noting that there may be slight deviations due to the switching time and/or delays in the local oscillator circuit). If the LO signal is a rectangular wave (or the mixer uses digital switching instead of linear), the resulting LO signal's spectrum is very rich in odd harmonics. If the LO signal is a perfect square wave, the $n^{th}$ harmonic has 1/n the amplitude of the base frequency $f_0$.

The local oscillator 318 may be a (digital) switching-type local oscillator that generates the LO signal using digital circuitry, such as counters, dividers, phase-locked loops (PLLs), or frequency synthesizers, to generate the desired clock signals. The local oscillator 318 may outputs the local oscillator signal and optionally one or more phase shifted versions thereof. The local oscillator 318 may be programmable to adjust or tune the clock frequency $f_0$ within a given clock frequency range, and optionally further to adjust a duty cycle and other timing parameters of the LO signal.

Due to the local oscillator outputting a rectangular wave signal as the LO signal, the LO signal includes components at the clock frequency $f_0$ and odd harmonics at odd multiples ($m \cdot f_0$, where $m$ is an odd integer number) of the clock frequency $f_0$. Note that the disclosure is not limited to the use of rectangular wave signal being output from the local oscillator circuit. Other oscillator waveforms can also be used as long as the local oscillator signal comprises the odd harmonics of the clock frequencies (and/or even harmonics thereof) that have a sufficient power level in the spectrum. For example, the local oscillator circuit may also output a sawtooth wave, a triangle-wave, etc. which may exhibit harmonics at sufficient power levels in their frequency spectrum.

To avoid that the analog multiplication of the RF input signal input to the frequency mixers 312 and 324 with the LO signal components at the clock frequency $f_0$ and its harmonics produce multiple images at unwanted mirror-frequencies, a bandpass filter 304 is used (e.g. instead of the lowpass filter 106 in Fig. 1) to remove frequency components in the RF input signal that are outside frequency span of the bandpass filter 304. The frequency span of the bandpass filter circuit 304 is selected to match with a desired one of the frequency components of the LO signal, i.e. a selected one of the clock frequency or the odd harmonics at one of the multiples of the clock frequency $f_0$. The bandpass filter may be further configured to reject frequencies of the other, non-selected harmonic frequencies (and clock frequency in case it is not the selected frequency). As exemplarily shown in Fig. 3 using the dotted arrow, the bandpass filter circuit 304 may be configurable, e.g. by means of a controller (not shown in Fig. 3). For example, the center frequency $f_{center}$ of the bandpass filter circuit 304 may be configured to match or correspond to the selected one of the clock frequency $f_0$ or the odd harmonics at multiples of the clock frequency $f_0$. Likewise, the pass band (e.g. upper and lower pass band frequencies) and/or stop band (e.g. upper and lower stop band frequencies) may be configurable. Further, as exemplarily shown in Fig. 3 using the dotted arrow, the local oscillator 318 may be configurable to tune to the LO signal to have a desired clock frequency $f_0$ (and its harmonics).

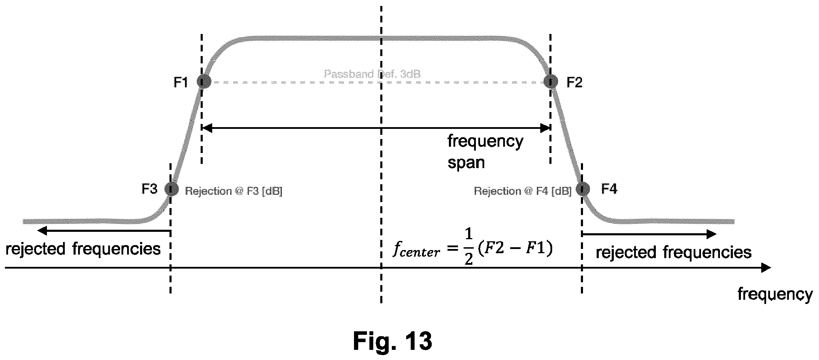

An example bandpass filter is shown in **Fig. 13.** For example, let's assume for exemplary purposes only that the local oscillator 318 is tunable to a clock frequency in the range of 50 MHz to 6 GHz. To measure a RF input signal received at RF connector 102 at a frequency around 12 GHz the local oscillator 318 may be tuned to $f_0$ = 4 *GHz* and the third harmonic at 12 GHz may be selected for mixing. In this case, the center frequency ($f_{center}$) of the bandpass filter 304 would be at 12 GHz. The bandpass filter 304 may be configured with a lower passband frequency F1 $\leq$ 11.9 GHz (e.g. = 3 $\cdot$ $f_0$ - *IBW/2*) and an upper passband frequency F2 $\geq$ 12.100 GHz (e.g. = 3 $\cdot$ $f_0$ + *IBW/2*) may be used to filter the RF input signal. The lower passband frequency F1 and upper passband frequency F2 define the frequency span of the pass band (also: bandwidth) of the bandpass filter 304 and may correspond to a maximum allowable loss or attenuation within the pass band (e.g. set at 3dB). In this example, the frequency span of the bandpass filter 304 is thus 200 MHz, centered at the frequency of the third harmonic at 12 GHz (=$f_{Center}$). In some example implementations, the bandwidth of the bandpass filter 304 may match with the instantaneous bandwidth (IBW) of the ADCs 316 and 328 (i.e. also IBW=200 MHz in the example) as defined by the sampling rate of the ADCs 316 and 328. In this latter case the lowpass filters 314 and 326 may not be necessary and may not be present.

Continuing the above example, the lower stop band frequency F3 of the bandpass filter 304 would have to remove/reject frequencies of the second harmonic (and lower frequencies), e.g.

$$F1 > F3 \geq 8.1 \text{ GHz } \left(= 2 \cdot 4\, GHz + \frac{200\, MHz}{2} = 2 \cdot f_0 + IBW/2\right)$$

, and the upper stop band frequency F4 of the bandpass filter 304 would have to remove/reject the fourth harmonic (and higher frequencies), e.g.

$$F2 < F4 \leq 15.9 \text{ GHz } \left(= 4 \cdot 4\, GHz - \frac{200\, MHz}{2} = 4 \cdot f_0 - IBW/2\right)$$

. The lower and upper stop band frequencies (F3, F4) may be defined to correspond to a minimum level of attenuation to effectively reject or attenuate signals, e.g. 6 dB or more. If the bandwidth BW of the bandpass filter 304 is not matched with the instantaneous bandwidth (IBW) of the ADCs 316 and 328, the instantaneous bandwidth IBW would need to be replaced by the bandwidth BW in the above equations for the frequencies F1, F2, F3 and F4.

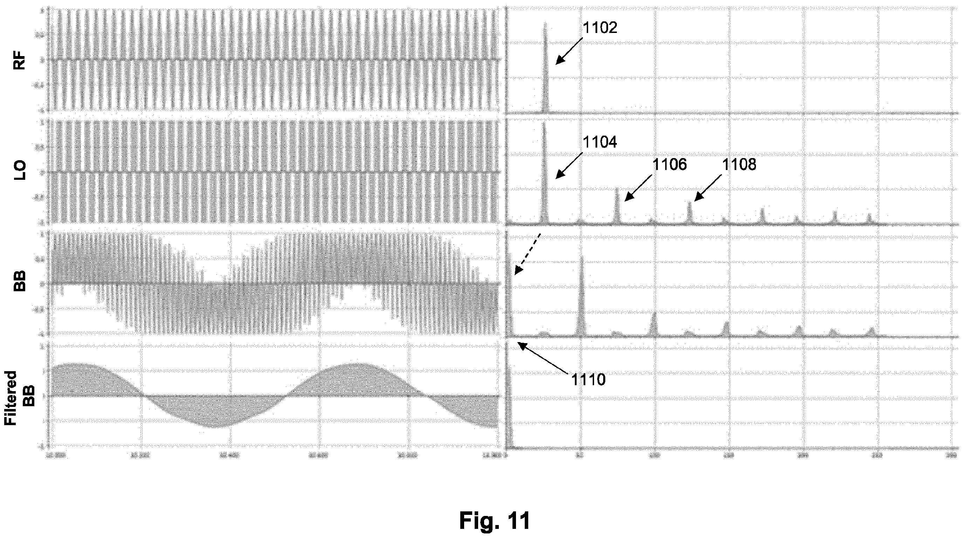

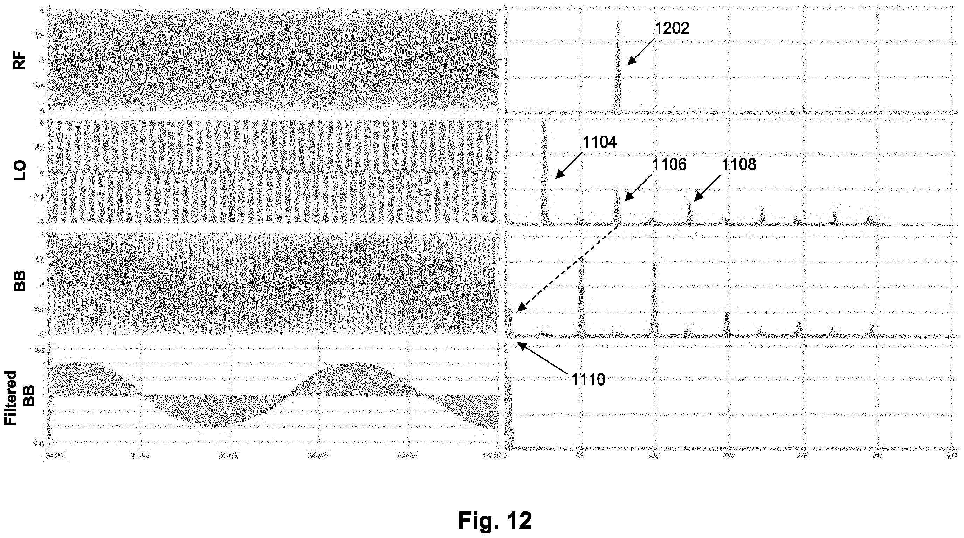

The above aspect is further highlighted in connection with **Figs. 11 and 12,** which show on their left side the time domain representation of a cosine wave signal ("RF"), the local oscillator signal ("LO") as provided to one of the frequency mixers 312 and 324 (the local oscillator signal of the other one of the frequency mixers 312 and 324 would be phase shifted by 90°, but the frequency representation would be identical), the baseband signal ("BB") output by said one of the frequency mixers 312 and 324, and the filtered baseband signal ("BB") output one of the lowpass filters 314 and 326. The x-axis shows the time, wherein the y-axis shows the amplitude of the signals.

The right side of **Fig. 11** and **Fig. 12** shows frequency domain representation of the signals. The x-axis shows the frequency, and the y-axis shows a power level of the signal.

In the time domain, the local oscillator signal ("LO") is a square wave signal with 50% duty cycle. Looking at its frequency domain representation, the local oscillator signal ("LO") has frequency components at its clock frequency $f_0$ indicated at 1104, and there are also even and odd harmonics of the clock frequency $f_0$ in the spectrum of the local oscillator signal ("LO"), wherein the even harmonics only have small power levels and may thus be neglectable. The 3rd and 5th harmonic of the clock frequency $f_0$ are indicated at 1106 and 1108, respectively.

If a spectrum analyzer intends to process and view a RF input signal ("RF") that is centered around a frequency of 5 GHz (see at 1102 in Fig. 11) and assuming that the local oscillator 318 is tunable to a clock frequency in the range of 0 to 6 GHz, the local oscillator signal may be tuned to $f_0$=5 GHz. Accordingly, the spectrum of the local oscillator signal ("LO") will show its fundamental frequency 1104 at 5 GHz, and the 3rd and 5th harmonics 1106 and 1108, are at 15 GHz and 25 GHz, respectively. The analog multiplication of the local oscillator signal ("LO") component at the clock frequency $f_0$=5 GHz with the RF input signal ("RF") around 5 GHz will thus shift the RF input signal into the baseband as illustrated in the spectrum of the baseband signal ("BB") wherein different harmonics of the local oscillator signal ("LO") will cause images of the RF input signal ("RF") in the spectrum. The baseband signal ("BB") may then be subjected to a lowpass filter to obtain the desired frequency component 1110 of the baseband signal ("BB") around the baseband signal frequency (commonly 0 Hz). Note that in this example, the power of the cosine wave RF input signal ("RF") is concentrated at 5 GHz which can be matched a clock frequency $f_0$=5 GHz. For this reason, the analog multiplication only generates the desired frequency component 1110 near baseband and other frequency components of the baseband signal resulting from the odd harmonics of the local oscillator signal ("LO") will be shifted in the spectrum by multiples of 10 GHz relative to the frequency component 1110. In a real-world scenario the RF input signal ("RF") may contain a broad spectrum of frequency components at different frequencies and the analog multiplication with the local oscillator signal ("LO") (including harmonics) would thus generate multiple shifted and aliased mirror images of the frequency components of the RF input signal ("RF"). To avoid this aliasing of several mirror images, the RF input signal ("RF") is "pre-processed" by applying a bandpass filter 304 that has a pass band matching with the tuned clock frequency $f_0$ or one of its odd harmonics to "pre-select" the frequencies of the RF input signal ("RF") for mixing.

This is further exemplified in connection with Fig. 12. Here it is assumed that the RF input signal ("RF") is a cosine wave signal at 15 GHz - see at 1202 - which corresponds to the 3rd harmonic 1106 of the local oscillator signal ("LO") when tuning the local oscillator 318 to the clock frequency $f_0$=5 GHz. One may likewise assume that the RF input signal ("RF") has been bandpass filtered with a bandpass filter having a pass band centered at 15 GHz. In this case, the 3rd harmonic 1106 of the local oscillator signal ("LO") shifts the RF input signal ("RF") to the baseband so that the desired image 1110 (at 0 Hz) can be obtained by lowpass filtering.

Hence, the combination of tuning the local oscillator 318 to a suitable clock frequency $f_0$ which matches or has one of the odd harmonic frequencies $m \cdot f_0$ matching with the frequency of the RF input signal at the RF connector 102 to be analyzes, and configuring the pass band of the bandpass filter circuit 304 to match with the tuned clock frequency $f_0$ or one of its odd harmonic frequencies $m \cdot f_0$ allows for analyzing RF inputs signal in a large frequency range (e.g. from the low kilohertz (kHz) range up to range of tens of GHz) without requiring a multi-stage mixer architecture and/or with reduced hardware complexity as regards the different filters in the RF path and/or IF path. Furthermore, when implementing the aspects of this disclosure in a spectrum analyzer, a controller of the spectrum analyzer may allow a user to tune the clock frequency $f_0$ of the local oscillator 318 to a selected frequency and to configure the pass band of the bandpass filter circuit 304, e.g. to program the center frequency of the pass band and the frequency span as pass band parameters ($f_{center}$, and frequency span BW, or $f_{center}$, F1 and F2) and optionally further the stop band parameters (e.g. F3 and F4) as explained in connection with Fig. 13.

Furthermore, the configurability or programmability of the local oscillator 318 and the bandpass filter circuit 304 also facilitate a sweeping operation over a large range of frequencies. A sweeping operation of the spectrum analyzer may be for example realized by a step-wise tuning the clock frequency $f_0$ of the local oscillator 318 to frequencies in the range of tunable frequencies and by adjusting the frequency span of the bandpass filter to include frequencies around each currently tuned clock frequency of the local oscillator or around its (odd) harmonics. The display device 122 may be further caused to visualize the RF input signal based on different baseband signals including signal components at frequencies around one of the odd harmonics of the local oscillator signal at the different tuned clock frequencies produced by this sweeping.

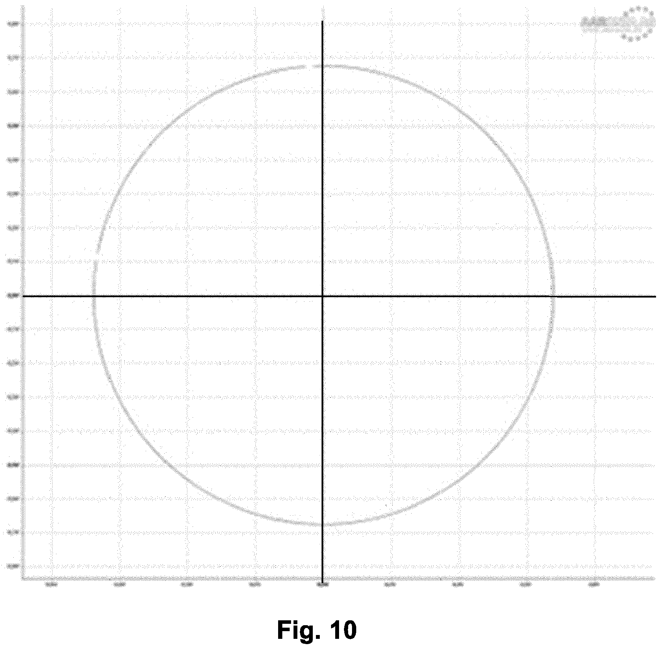

As noted above, the I components and Q component of the RF input signal may be displayed on a display device 122. Ideally, a vector scope of a continuous wave signal as an RF input signal at the RF connector 102 should result in a perfect circle on the display device 122 as shown in **Fig. 10.**

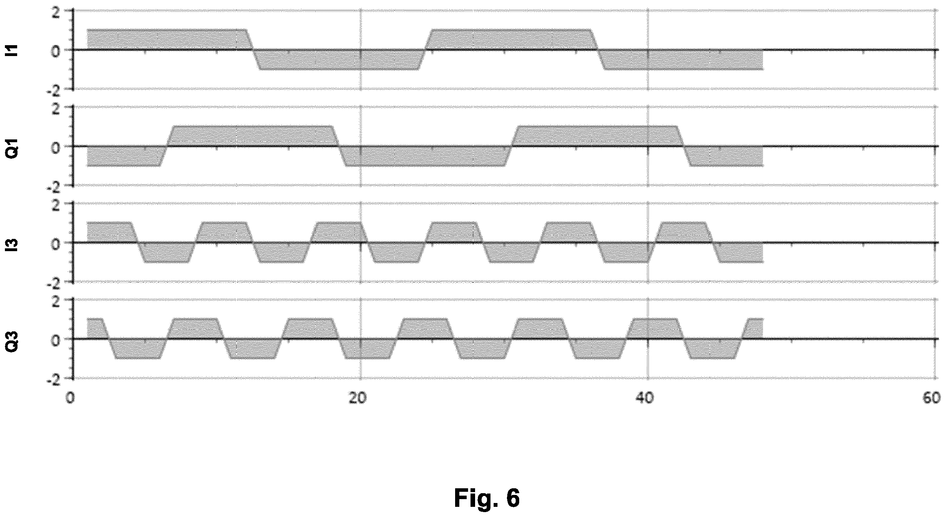

However, when selecting one of the (odd) harmonics of the LO signal for mixing, the lower power of the harmonics in the baseband signals provided by mixers 312 and 324 and some other changes in the baseband signal may need to be corrected in digital post processing 330 as indicated in Fig. 3 and Fig. 4, which constitutes another aspect of this disclosure. For example, depending on which of the odd harmonics of the clock frequency $f_0$ is selected, the sequence of samples of the I components and Q component might need phase compensation. For example, as shown in **Fig. 6,** the Q component Q1 of the first harmonic trails the I component I1 component of the first harmonic by a quarter of a circle (i.e. 90°). In the third harmonic, the I component I3 component trails the Q component Q3 component by a quarter of a circle (i.e. 90°). For the third harmonics of the LO signal, the I and Q components of may sometimes have different power levels due to manufacturing variances in the two clock paths from the local oscillator 318 to the mixers 316 and 324 or within the mixers 316 and 324. There is usually also a small error in the phase offset between the I component and the Q component, which is more pronounced in the harmonics due to the shorter period of the LO signal.

In some embodiments, these types of errors may be estimated by analyzing a relative long (in the range of milliseconds) sequence of time-discrete I and Q samples output by the ADCs 316 and 328. The sequence of I and Q samples may for example be buffered for processing in some memory for signal processing 330. When performing the signal processing 330 in a real-time spectrum analyzer, in an attempt to avoid a long calibration of spectrum analyzer, the correction of the I and Q components output by the ADCs 316 and 328 may be applied to the buffered data of the I and Q components in a retro-active way: The I and Q components' data may be buffered or queued, while the error estimation is performed on the queued data, and the error correction is applied to the queued data prior to the visualization of the I and Q components' data. This may require the caching of 10s or 100s of millions of I and Q samples, and the spectrum analyzer may be equipped with some volatile memory (e.g. a DRAM, SRAM, or the like) to buffer the I and Q samples for error estimation and error correction. The buffered I and Q samples may be continuously updated in a first in-first out (FIFO) scheme, and error estimation may be performed for example periodically to continuously update the correction parameters applied in error correction.

**Fig. 4** shows an example of the signal processing 330 that may be performed on the I and Q samples output by the ADCs 316 and 328. The signal processing may be for example performed using a multi-tap filter bank that includes the queuing circuit to perform the above noted error estimation(s). In other example implementations, one or more of or a combination of central processing unit (CPU), a field programmable gate array (FPGA), programmable logic device (PLD), application specific integrated circuit (ASIC), a digital signal processor (DSP), or other processing elements may be used perform the signal processing 330. Those processing elements may be for example included in spectrum analyzer or a PC that can implement spectrum analyzer functionality.

The signal processing 330 may include the above noted signal correction processing 402. The signal correction processing 402 may include one or more of the following: Phase offset estimation and compensation 404 of the I and Q samples, DC offset estimation and compensation 406 of the I and Q samples and/or scaling 408 of the I and Q samples. The signal processing 330 may further include converting 410 the I and Q samples from their time domain representation into a frequency domain representation. This conversion 410 may be for example implement a Fast Fourier Transform (FFT) or Discrete Cosine Transform (DCT) on (blocks of) I samples and on (blocks of) Q samples to generate frequency domain representations of the I samples and the Q samples, respectively. Further, the signal processing 330 may include video-bandwidth filtering 412 (similar to block 120 in Fig. 1) of the frequency domain representations of the I and Q samples, for subsequent visualization on the display device 122.

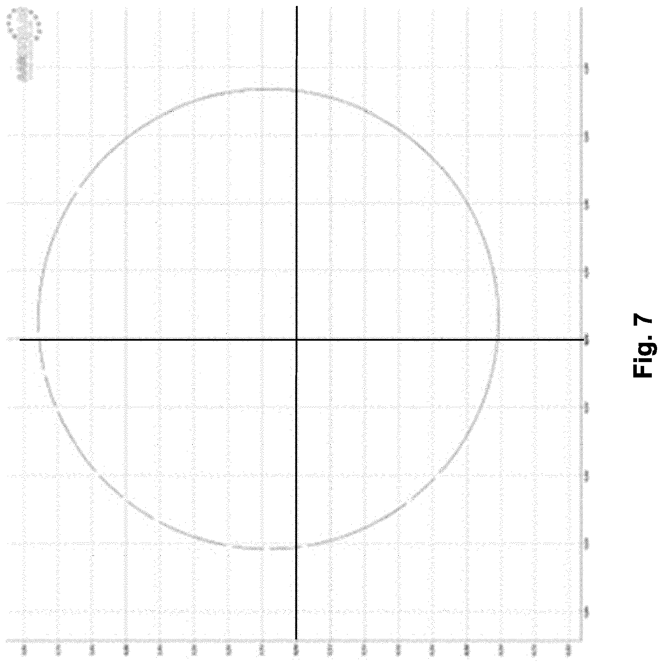

As regards the DC offset estimation and compensation 406 of the I and Q samples, **Fig. 7** shows an example where different DC offsets are present in the I and Q samples. It is commonly desirable that the power levels of I and Q samples have a zero total sum. For correction of the DC offset, the averages of a long sequence of I and Q samples form respective DC power offset estimates $I_{dc}$ and $Q_{dc}$ and can be subtracted from the I and Q samples $I[i]$ and $Q[i]$ for correction of the DC power offset:

$$I_{comp}[i] = I[i] - I_{dc} \qquad (1)$$

$$Q_{comp}[i] = Q[i] - Q_{dc} \qquad (2)$$

where $I_{comp}[i]$ and $Q_{comp}[i]$ are the corrected I and Q samples.

The DC power offset estimates $I_{dc}$ and $Q_{dc}$ can be determined as follows:

$$I_{dc} = \frac{1}{n} \sum_{i=1}^{n} I_i \qquad (3)$$

$$Q_{dc} = \frac{1}{n} \sum_{i=1}^{n} Q_i \qquad (4)$$

wherein $I_i$ and $Q_i$ are the I and Q components of a sequence of n samples of the time-discrete baseband signal, which may be buffered/queued. The DC power offset estimates $I_{dc}$ and $Q_{dc}$ may be calculated and updated for each of successive sequences of n samples, may be calculated and updated periodically for a sequence of the n latest samples that have been buffered, or the like.

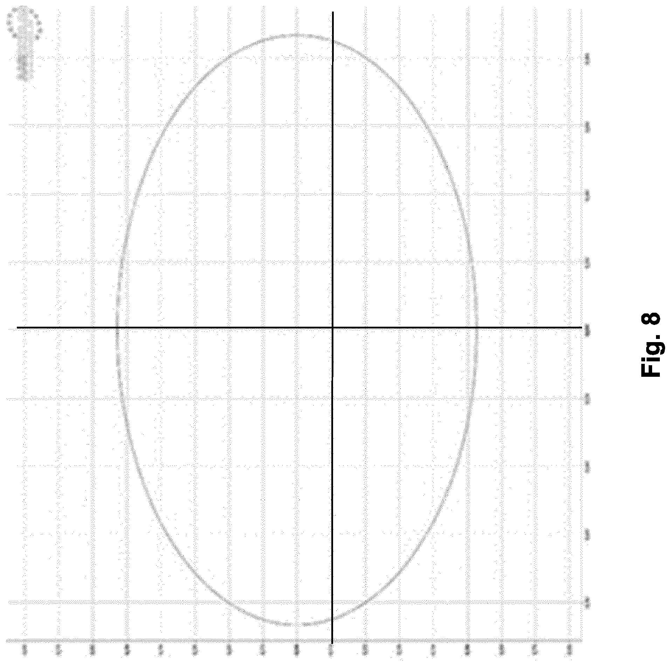

Further, as regards scaling 408 of the I and Q samples, it is commonly desirable that the average sum of absolute values of I and Q samples (after DC power offset correction) is identical, because both paths represent the same signal, just with a phase offset. An example, where average sum of absolute values of I and Q samples is not identical (e.g. due to the different scaling in ADCs 316, 328) is exemplarily shown in the vector scope image of Fig. 8. Using the ratio of the square root of the averages of the squares of I and Q sample values minus the square of the averages of I and Q sample values, the correction factor of scaling factor $I_{scale}$ can be estimated:

$$I_{scale} = \sqrt{\frac{\frac{1}{n}\sum_{i=1}^{n} I_i{}^2 - \left(\frac{1}{n}\sum_{i=1}^{n} I_i\right)^2}{\frac{1}{n}\sum_{i=1}^{n} Q_i{}^2 - \left(\frac{1}{n}\sum_{i=1}^{n} Q_i\right)^2}} \qquad (5)$$

This scaling factor $I_{scale}$ is multiplied with all Q samples and all I samples are divided by the scaling factor $I_{scale}$:

$$I_{comp}[i] = \frac{I[i]}{I_{scale}} \qquad (6)$$

$$Q_{comp}[i] = Q[i] \cdot I_{scale} \qquad (7)$$

where $I_{comp}[i]$ and $Q_{comp}[i]$ are the scaled I and Q samples, and $I[i]$ and $Q[i]$ are the I and Q sample values. Note that DC offset correction and scaling may be applied to all I and Q samples as well.

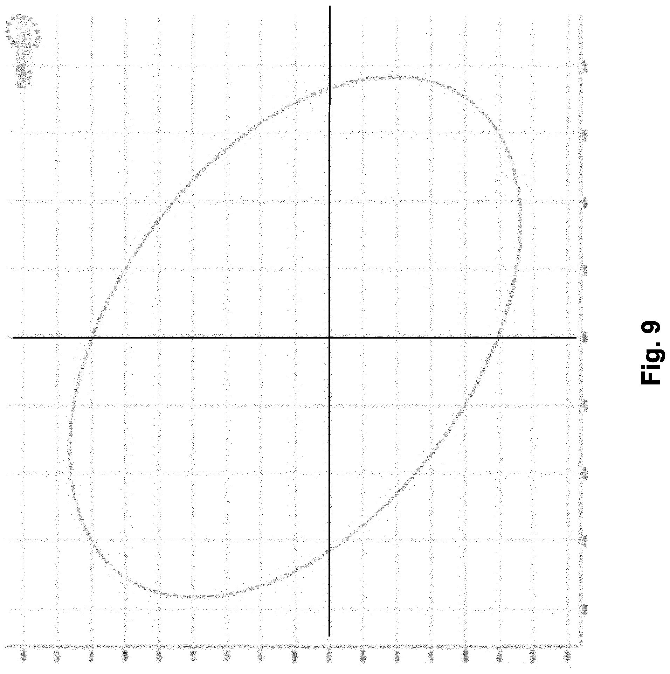

Furthermore, with respect to phase error estimation and compensation 404, it would be desirable that the phase offset between I and Q samples is 90 degrees. Fig. 9 shows a vector scope image where the phase offset between the I and Q samples is not 90°. The phase offset $\varphi_{phase}$ may be estimated using the arc tan of the quotient of two times the average of the product of I and Q sample values with the difference of the average of the squares of I and Q sample values:

$$\varphi_{phase} = -\frac{1}{2} tan^{-1} \frac{2\left(\frac{1}{n}\sum_{i=1}^{n} I_i Q_i - \left(\frac{1}{n}\sum_{i=1}^{n} I_i\right)\left(\frac{1}{n}\sum_{i=1}^{n} Q_i\right)\right)}{\left[\frac{1}{n}\sum_{i=1}^{n} I_i{}^2 - \left(\frac{1}{n}\sum_{i=1}^{n} I_i\right)^2\right] - \left[\frac{1}{n}\sum_{i=1}^{n} Q_i{}^2 - \left(\frac{1}{n}\sum_{i=1}^{n} Q_i\right)^2\right]} \qquad (8)$$

This phase offset $\varphi_{Phase}$ is used to rotate either the I samples or the Q samples to achieve a 90-degree phase shift between these two signal components. The compensation of the phase offset $\varphi_{phase}$ may be applied in addition to DC offset compensation and/or scaling as discussed herein above.

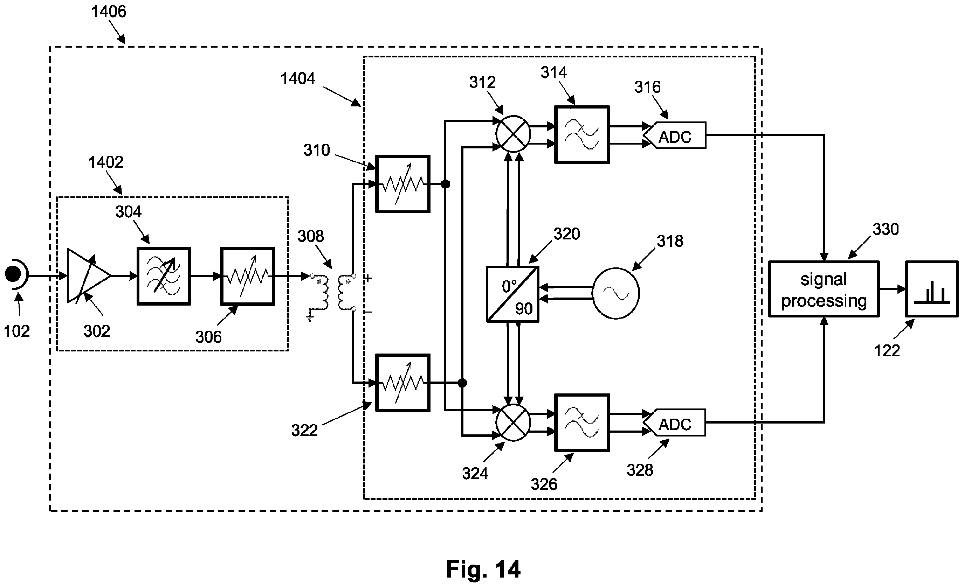

Another aspect of this disclosure is the implementation of the different aspects of this disclosure in hardware and or software. For example, the signal processing exemplified in block 330 may be for example implemented in software, or hardware or a combination of both. **Fig. 14** highlights different possibilities for implementing the aspects of this disclosure in hardware (e.g. integrated circuits). Fig. 14 reproduces the example block diagram of a zero-IF receive chain in accordance with Fig. 3 to facilitate a better understanding of different options for implementing functional blocks of the block diagram in hardware and/or software. For example, as shown by the dashed rectangular blocks 1402 and 1404, the different blocks/functionality of the block diagram in Fig. 3 may be implemented, for example, in different integrated circuits (ICs)/chips. For example, the functionality of the adaptive bandpass filter circuit 304 and optionally the functionality of the RF amplifier 302 and/or the RF attenuator 306 (and optionally other functionality or circuitry of the RF path) could be implemented in an IC as shown by block 1402. Further optionally, an on-chip implementation of the balun 308 is possible, which could be also part of such IC implementing the RF path.

The baseband (BB) path (including the I-Q mixer stage) designated by reference numerals 310 to 328 may be implemented in another IC as shown by block 1404. This other IC, noting that some of the blocks/functionality (e.g. and not limited to the RF attenuators 310, 322 and/or lowpass filters 314, 316) may be optional and thus not implemented on the IC. Further, the IC may also include additional functionality not shown in Figs. 3, 4 or 14. Optionally, some or all functionality of the signal processing block 330 (e.g. one or more of functionality selected from frequency domain conversion 410, video bandwidth filtering 412, and signal correction processing 402) can also be implemented in this IC, e.g. to provide a System-on-Chip (SoC) that provides a stream of I samples and Q samples of the RF radio signal at the input connector 102, where errors are compensated, so another device or circuitry (e.g. for display). Further, some functionality, e.g. but not limited to the local oscillator 318 and/or phase shifting element 320 and/or ADCs 316, 328, may also be implemented off-chip, e.g. in another IC.

In another example implementation, the blocks/functionality of the RF path and the baseband (BB) path (and optionally some or all functionality of the signal processing of block 330) can also be implementing in one IC as indicated by block 1406. Such IC may be also denoted SoC. In yet another implementation, the blocks 1402 and 1404 may designate distinct ICs with may be jointly provided in a system-package (SiP), multi-chip package or 2D, 2.5D or 3D multi-chip module (MCM).

The foregoing description of one or more implementations provides illustration and description, but is not intended to be exhaustive or to limit the scope of embodiments to the precise form disclosed. Modifications and variations are possible in light of the above teachings or may be acquired from practice of various embodiments.

**Claims**

1.  A spectrum analyzer device, comprising:

    radio-frequency path comprising at least a bandpass filter circuit, wherein the bandpass filter circuit is configured to receive a time-continuous radio-frequency input signal and to output a bandpass-filtered radio frequency input signal that has frequency components that are outside a predetermined or configurable frequency span of the bandpass filter removed; and
    a direct-conversion circuit configured to receive the bandpass-filtered time-continuous radio frequency input signal, wherein the direct-conversion circuit comprises a local oscillator circuit configured to provide a local oscillator signal, wherein the local oscillator signal includes signal components at a clock frequency and odd harmonics at odd multiples of the clock frequency;
    wherein the predetermined or configurable frequency span of the bandpass filter includes frequencies around one of the odd harmonics of the local oscillator signal output from the local oscillator;
    wherein the direct-conversion circuit comprises a mixer circuit configured to receive the local oscillator signal including said signal components at a clock frequency and odd harmonics at odd multiples of the clock frequency and said bandpass-filtered time-continuous radio frequency input signal, and to perform down-conversion by mixing the local oscillator signal and the bandpass-filtered time-continuous radio frequency input signal, thereby generating a time-continuous baseband signal including signal components at frequencies around said one of the odd harmonics of the local oscillator signal; and
    wherein the spectrum analyzer device further comprises a display device configured to visualize the continuous radio-frequency input signal based on the baseband signal including said signal components at frequencies around said one of the odd harmonics of the local oscillator signal.

2.  The spectrum analyzer device according to claim 1, wherein the frequency span has a predetermined or configurable center frequency, wherein the center frequency corresponds to said one of the odd harmonics of the local oscillator signal.

3.  The spectrum analyzer device according to claim 1 or 2, further comprising an analog-to-digital conversion circuit configured to convert the time-continuous baseband signal into a time-discrete baseband signal.

4.  The spectrum analyzer device according to claim 3, wherein the frequency span has a predetermined or configurable bandwidth around a center frequency, wherein the bandwidth corresponds to the instantaneous bandwidth of the analog-to-digital circuit defined by its sampling rate.

5.  The spectrum analyzer device according to one of claims 1 to 4, wherein the baseband filter is configured to reject frequency components of the time-continuous radio-frequency input signal at the clock frequency and the odd harmonics other than said one of the odd harmonics of the local oscillator signal.

6.  The spectrum analyzer device according to one of claims 1 to 5, further comprising:

    a time-frequency conversion circuit configured to transform the time-discrete baseband signal into the frequency domain thereby producing a frequency domain representation of the baseband signal;
    wherein the display device is configured to visualize the frequency domain representation of the baseband signal.

7.  The spectrum analyzer device according to one of claims 1 to 6, wherein the direct-conversion circuit is an in-phase-quadrature mixer circuit, IQ mixer circuit configured to mix the local oscillator signal and the bandpass-filtered time-continuous radio frequency input signal, thereby generating an in-phase, I, component of the time-continuous baseband signal including signal components at frequencies around said one of the odd harmonics of the local oscillator signal, and to mix the a $\pi/2$-shifted version of the local oscillator signal and the bandpass-filtered time-continuous radio frequency input signal, thereby generate a quadrature, Q, component of the time-continuous baseband signal including signal components at frequencies around said one of the odd harmonics of the local oscillator signal.

8. The spectrum analyzer device according to claim 7, further comprising further comprising:

a compensation circuit configured to compensate a phase shift between the I component and Q component of the time-discrete baseband signal,
wherein the compensation circuit is configured to estimate the phase shift $\Delta_{phase}$ using:

$$\Delta_{phase} = -\frac{1}{2}\tan^{-1}\frac{2\left(\frac{1}{n}\sum_{i=1}^{n}I_iQ_i - \left(\frac{1}{n}\sum_{i=1}^{n}I_i\right)\left(\frac{1}{n}\sum_{i=1}^{n}Q_i\right)\right)}{\left[\frac{1}{n}\sum_{i=1}^{n}I_i^2 - \left(\frac{1}{n}\sum_{i=1}^{n}I_i\right)^2\right] - \left[\frac{1}{n}\sum_{i=1}^{n}Q_i^2 - \left(\frac{1}{n}\sum_{i=1}^{n}Q_i\right)^2\right]}$$

wherein $I_i$ and $Q_i$ are the I and Q components of a sequence of n samples of the time-discrete baseband signal.

9. The spectrum analyzer device according to claim 7 or 8, further comprising:

a compensation circuit configured to compensate for a DC offset in the I and Q components of the time-discrete baseband signal by subtracting an average of a sequence of n samples of the I components and an average of sequence of n samples of the Q components from the I and Q components, respectively, prior to visualization, wherein the compensation circuit is further configured to scale the I and Q components based on a ratio of the square root of the averages of the squares of the sequence of n samples of I components minus the square of the averages of the sequence of n samples of I components and the square root of the averages of the squares of the sequence of n samples of Q components minus the square of the averages of the sequence of n samples of Q components.

10. The spectrum analyzer device according to one of claims 7 to 9, further comprising a queuing circuit configured to queue a sequence of n samples of the I and Q components of the time-discrete baseband signal.

11. The spectrum analyzer device according to one of claims 7 to 10, further comprising a time-frequency conversion circuit configured to transform the I component and Q component of the time-discrete baseband signal into the frequency domain thereby producing a frequency domain representation of the I and Q components of the baseband signal;
wherein the display device is configured to visualize the frequency domain representation of the I and Q components of the baseband signal.

12. The spectrum analyzer device according to one of claims 1 to 11, wherein the local oscillator signal is a local oscillator signal is a rectangular wave signal.

13. The spectrum analyzer according to one of claims 1 to 12, wherein the local oscillator is tunable to a clock frequency within a range of clock frequencies, wherein the local oscillator signal includes signal components at the tuned clock frequency and odd harmonics at odd multiples of the tuned clock frequency,

comprising a controller configured to sweep the range of clock frequencies by step-wise tuning the local oscillator to the clock frequencies in said range and adjust the frequency span of the bandpass filter to include frequencies around each currently tuned clock frequency of the local oscillator or one of its odd harmonics in said sweeping; wherein spectrum analyzer is further configured to cause the display device configured to visualize the continuous radio-frequency input signal based on different baseband signals including signal components at frequencies around one of the odd harmonics of the local oscillator signal at the different tuned clock frequencies produced by said sweeping.

14. A method executed in a system for processing a continuous radio-frequency input signal for display, the method comprising:

in a radio-frequency path, performing a bandpass filtering on a time-continuous radio-frequency input signal to produce a bandpass-filtered radio frequency input signal that has frequency components that are outside a predetermined or configurable frequency span of the bandpass filter removed; and

performing a direct down conversion of the bandpass-filtered time-continuous radio frequency input signal into a baseband signal, wherein the direct down conversion comprises mixing a local oscillator signal including signal components at a clock frequency and odd harmonics at odd multiples of the clock frequency and said bandpass-filtered time-continuous radio frequency input signal, thereby generating the baseband signal, wherein the baseband signal includes signal components at frequencies around said one of the odd harmonics of the local oscillator signal.

15. The method of claim 14, further comprising:

converting the time-continuous baseband signal into a time-discrete baseband signal;

transforming the time-discrete baseband signal into the frequency domain thereby producing a frequency domain representation of the baseband signal, and

causing a display device to visualize the continuous radio-frequency input signal on a display device based on the baseband signal including said signal components at frequencies around said one of the odd harmonics of the local oscillator signal; wherein the baseband filtering rejects frequency components of the time-continuous radio-frequency input signal at the clock frequency and the odd harmonics other than said one of the odd harmonics of the local oscillator signal.

**Fig. 1**

**Fig. 2**

**Fig. 3**

**Fig. 4**

Quadrature Clock Phases

$LO_0$
$LO_{90}$
$LO_{180}$
$LO_{270}$

Quadrature Sampling Mixer

$I_+$  $I_-$  $Q_+$  $Q_-$

$IN_+$  $IN_-$

$LO_0$  $LO_{180}$  $LO_{180}$  $LO_0$  $LO_{90}$  $LO_{270}$  $LO_{270}$  $LO_{90}$

Fig. 5

Fig. 6

Fig. 7

**Fig. 8**

Fig. 9

Fig. 10

**Fig. 11**

EP 4 474 834 A1

**Fig. 12**

Fig. 13

signal processing

ADC

ADC

0° 90

Fig. 14

Europäisches
Patentamt

European
Patent Office

Office européen
des brevets

# EUROPEAN SEARCH REPORT

**Application Number**

EP 23 17 8080

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | GB 2 269 501 A (HEWLETT PACKARD CO [US]) 9 February 1994 (1994-02-09) | 1-8, 10-15 | INV. G01R23/165 |
| A | * page 2, line 20 - page 16, line 21; figures 1,3,7 * | 9 | |
| A | US 2014/240605 A1 (BASAWAPATNA GANESH RAMASWAMY [US] ET AL) 28 August 2014 (2014-08-28) * paragraph [0014] - paragraph [0015]; claims 1,3; figure 1 * | 1-15 | |
| A | CN 115 208 323 A (NANJING LUODA INFORMATION CO LTD) 18 October 2022 (2022-10-18) * claims 1,7 * | 1-15 | |
| A | US 2009/140732 A1 (SHRINKLE LOU [US] ET AL) 4 June 2009 (2009-06-04) * figure 4 * | 1-15 | |
| A | US 5 162 723 A (MARZALEK MICHAEL S [US] ET AL) 10 November 1992 (1992-11-10) * claim 2 * | 1-15 | TECHNICAL FIELDS SEARCHED (IPC)  G01R |
| A | US 3 634 760 A (MURTIN FERNAND R C ET AL) 11 January 1972 (1972-01-11) * figure 1 * | 1-15 | |
| A | EP 4 033 258 A1 (ROHDE & SCHWARZ [DE]) 27 July 2022 (2022-07-27) * paragraph [0114] * | 1-15 | |
| A | US 7 944 984 B1 (WU SONGPING [US] ET AL) 17 May 2011 (2011-05-17) * claim 1 * | 1-15 | |

The present search report has been drawn up for all claims

| Place of search | Date of completion of the search | Examiner |
|---|---|---|
| Munich | 30 November 2023 | Meliani, Chafik |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 23 17 8080

This annex lists the patent family members relating to the patent documents cited in  the above-mentioned European search report.
The members are as contained in the European Patent Office EDP file on
The European Patent Office is in no way liable for these particulars which are merely given for the purpose of information.

30-11-2023

| Patent document cited in search report | | Publication date | Patent family member(s) | | Publication date |
|---|---|---|---|---|---|
| GB 2269501 | A | 09-02-1994 | DE | 4325058 A1 | 03-02-1994 |
| | | | GB | 2269501 A | 09-02-1994 |
| | | | JP | H06148242 A | 27-05-1994 |
| US 2014240605 | A1 | 28-08-2014 | NONE | | |
| CN 115208323 | A | 18-10-2022 | NONE | | |
| US 2009140732 | A1 | 04-06-2009 | JP | 5783667 B2 | 24-09-2015 |
| | | | JP | 2009139382 A | 25-06-2009 |
| | | | US | 2009140732 A1 | 04-06-2009 |
| US 5162723 | A | 10-11-1992 | DE | 4203819 A1 | 20-08-1992 |
| | | | GB | 2253550 A | 09-09-1992 |
| | | | JP | 3444904 B2 | 08-09-2003 |
| | | | JP | H05196649 A | 06-08-1993 |
| | | | US | 5162723 A | 10-11-1992 |
| US 3634760 | A | 11-01-1972 | NONE | | |
| EP 4033258 | A1 | 27-07-2022 | EP | 4033258 A1 | 27-07-2022 |
| | | | US | 2022239392 A1 | 28-07-2022 |
| US 7944984 | B1 | 17-05-2011 | NONE | | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **JAIN et al.** Recent Developments in Integrated Interferer-Tolerant Receivers for Reconfigurable Radios. *IEEE Journal of Microwaves,* July 2021, vol. 1 (3